# EUROPÄISCHE PATENTSCHRIFT

(11) **EP 1 971 706 B1**
(45) Veröffentlichungstag und Bekanntmachung des Hinweises auf die Patenterteilung: **25.07.2018**
(21) Anmeldenummer: 07700189.9
(22) Anmeldetag: 05.01.2007
(51) Int. Cl.: C23C 28/00, C23C 14/02, C23C 14/06, C23C 14/32

(54) **GEGENSTAND, DER EIN RELATIV WEICHES TRÄGERMATERIAL UND EINE RELATIV HARTE DEKORATIVE SCHICHT AUFWEIST, SOWIE VERFAHREN ZU DESSEN HERSTELLUNG**
OBJECT COMPRISING A RELATIVELY SOFT CARRIER MATERIAL AND A RELATIVELY HARD DECORATIVE LAYER, AND METHOD FOR THE PRODUCTION THEREOF
OBJET PRESENTANT UN MATÉRIAU DE SUPPORT RELATIVEMENT SOUPLE ET UNE COUCHE DÉCORATIVE RELATIVEMENT RIGIDE ET PROCÉDÉ POUR LE PRODUIRE

(30) Priorität: 13.01.2006 DE 102006001860; 16.01.2006 DE 102006002034
(43) Veröffentlichungstag der Anmeldung: 24.09.2008
(73) Patentinhaber: IHI Hauzer Techno Coating B.V., 5928 LL Venlo (NL)
(72) Erfinder: EERDEN, Michiel, NL-5664 AD Geldrop (NL); LANDSBERGEN, Jeroen, NL-5684 BN Best (NL); PEETERS, Paul, NL-5615 NC Eindhoven (NL); STRONDL, Christian, NL-5913 RN Venlo (NL); TIETEMA, Roel, NL-5926 SK Venlo (NL)
(74) Vertreter: Manitz Finsterwald Patentanwälte PartmbB
(86) Internationale Anmeldenummer: PCT/EP2007/000075
(87) Internationale Veröffentlichungsnummer: WO 2007/082645

(56) Entgegenhaltungen:
- EP-A- 0 430 874
- JP-A- 2004 010 923
- US-A- 4 992 153
- US-A1- 2005 196 636
- US-A1- 2005 242 156
- B. NAVINSÊK, P. PANJAN ET AL: "PVD COATINGS AS AN ENVIRONMENTAL CLEAN ALTERNATIVE TO ELECTROPLATING AND ELECTROLESS PROCESSES" SURFACE AND COATINGS TECHNOLOGY, Bd. 116-119, 1. September 1999 (1999-09-01), Seiten 476-487, XP002465272 NL

## Beschreibung

Die vorliegende Erfindung betrifft einen Gegenstand, der ein relativ weiches Trägermaterial gegebenenfalls eine auf dem Trägermaterial aufgebrachte Haftschicht bzw. ein Haftschichtsystem und eine relativ harte dekorative Schicht umfasst. Ferner befasst sich die Erfindung mit einem Verfahren zur Herstellung eines solchen Gegenstands. Solche Gegenstände und entsprechende Verfahren sind an sich bekannt, beispielsweise auf dem Gebiet der Baubeschläge, bei denen ein Gegenstand aus Messing, wie ein Türgriff, mit einer harten dekorativen Beschichtung versehen wird, wie beispielsweise in der DE-A-10011597 der vorliegenden Anmelderin beschrieben ist.

Es gibt in der Praxis eine Vielzahl von weiteren Gegenständen, die mit einer dekorativen Schicht versehen werden sollen. Beispiele sind kleinere Geräte der Consumerelektronik wie insbesondere MP3-Player, tragbare Radios, Mobiltelefone usw., bei denen ein Kunststoffgehäuse, das aus dem Trägermaterial besteht, mit einer farbigen dekorativen Schicht, beispielsweise in einer Aluminiumfarbe oder in einer schwarzen Farbe, versehen werden soll. Auch sind solche Geräte mit einem Gehäuse aus einem weichen Metall wie Aluminium, Messing, Edelstahl oder ähnlichem bekannt, die ebenfalls mit einer dekorativen Schicht ausgestattet werden sollen. Selbst ein Trägermaterial aus Aluminium, Messing, Edelstahl oder ähnlichem stellt aber letztendlich ein relativ weiches Trägermaterial dar, z.B. mit einer Vickershärte HV_{0.025} im Bereich von etwa 200 bis etwa 300. Egal, ob solche Gegenstände aus Kunststoff oder aus einem relativ weichen Metall bestehen, zeigen sie nach relativ kurzer Zeit Gebrauchsspuren auf, beispielsweise aufgrund der häufigen Handhabung durch den Benutzer oder durch das Tragen des entsprechenden Geräts in einer Tasche oder auf einem vibrierenden Untergrund, wie beispielsweise in einem PKW.

Es besteht daher bei einer Vielzahl derartiger Gegenstände, insbesondere Gebrauchsgegenstände, der Wunsch, den entsprechenden Gegenstand mit einer dekorativen Schicht zu versehen, der gegen Abkratzen und Abnutzung der dekorativen Schicht wesentlich widerstandsfähiger ist als bisher.

Der Anmelderin ist bewusst geworden, dass das Problem der Beschädigung der dekorativen Schicht, bei dekorativen Schichten, die durch PVD-Verfahren oder CVD-Verfahren erzeugt werden, nicht in der Zusammensetzung der Schicht selbst zu suchen ist, da solche dekorativen Schichten relativ dünn und relativ hart sind, wenigstens härter als das Trägermaterial, sondern dass das Problem viel eher in den relativ weichen Substraten seine Ursache hat, da diese relativ leicht zerkratzen bzw. anderweitig beschädigt werden, so dass beispielsweise durch die Einwirkung von entsprechenden Kräften das weiche Trägermaterial eingedrückt wird, was zu einer Verschlechterung des Aussehens der dekorativen Schicht oder zu einem lokalen Abplatzen dieser Schicht führen kann. Das gleiche Problem tritt bei Trägermaterialien aus Kunststoff auf.

Ferner ist erfindungsgemäß erkannt worden, dass diese Problematik dadurch überwunden werden kann, in dem eine relativ dicke harte Schicht, beispielsweise aus Cr, mittels eines galvanischen Verfahrens auf den Gegenstand aufgebracht wird. Bei Gegenständen aus Aluminium oder Zinkdruckguss ist es ebenfalls bekannt, eine Hartchromschicht auf galvanischem Weg vorzusehen, die zusätzlich als Korrosionsschutzschicht wirkt, auf die dann eine dekorative Schicht aufgebracht werden kann. Solche Hartchromschichten haben aber den Nachteil, dass die entsprechenden galvanischen Bäder Chrom VI enthalten, das toxisch und aus Gesundheitsgründen unerwünscht ist.

Bei Trägermaterialien aus Kunststoff ist es bekannt, ein Haftvermittlerschichtsystem bestehend aus einer ersten Cu-Schicht und einer zweiten Ni-Schicht mit einer Dicke von unter 1 µm galvanisch aufzubringen, wobei es sich hier um relativ weiche Schichten handelt. Dieses Haftvermittlerschutzsystem wird anschließend mit einer Hartchromschicht mit einer Dicke von etwa 10 bis 20 µm versehen, bevor die eigentliche dekorative Schicht aufgebracht wird.

Bei leitfähigen Gegenständen ist es darüber hinaus bekannt, eine dünne Haftvermittlerschicht mit einer Dicke von weniger als 1 µm mit einem PVD-Verfahren abzuscheiden und auf diese dann eine Stützschicht aus Chrom oder Chromnitrid mit einer Dicke von 1 bis 3 µm ebenfalls unter Anwendung eines PVD-Verfahrens anzubringen, bevor die eigentliche dekorative Schicht abgeschieden wird.

Abgesehen von der Problematik der Toxizität von Hartchrombädern mit Chrom VI ist es aber auch nachteilig, dass in allen Fällen eine Cr-Schicht von erheblicher Dicke von mehreren µm erforderlich ist, um gute Ergebnisse zu liefern. Eine relativ dicke Cr-Schicht dieser Art braucht aber eine relativ lange Anbringungszeit, was das Herstellungsverfahren teuer macht. Ferner stellt Cr ein relativ teures Material dar, vor allem, wenn es darum geht, Gegenstände, die in großen Stückzahlen hergestellt werden, mit einer entsprechend dicken Cr-Schicht zu versehen.

Nach der Anbringung einer solchen harten Schicht, die eine ausreichende Dicke aufweist, ist die Gefahr des Zerkratzens oder der Beschädigung des Trägermaterials deutlich geringer und kann bei dem so erzeugten Gegenstand bestehend aus einem Trägermaterial, einer harten Cr-Schicht und einer mittels eines PVD- oder CVD-Verfahrens abgelagerten dekorativen Schicht überwunden werden.

Die EP-A-0 430 874 weist einen beschichteten Gegenstand auf, dessen Beschichtung eine Dekorschicht, eine Übergangschicht und eine Trennschicht umfasst. Die Dekorschicht kann aus einer Hartstoffschicht und einer farbtonbestimmenden Schicht bestehen.

Weiterer Stand der Technik wird in JP 2004 010923 A, US 2005/242156 A1, US 2005/196636 A1, US 4,992,153, sowie der Veröffentlichung von B. Navinsek et al. mit dem Titel: "PVD coatings as an environmental clean alternative to electroplating and electroless process" veröffentlicht in SURFACE & SURFACE COATINGS TECHNOLOGY Bd. 116-119 am 1. September 1999 auf den Seiten 476-487 offenbart.

Aufgabe der vorliegenden Erfindung ist es daher, Gegenstände aus einem relativ weichen Trägermaterial und einer an der Oberfläche vorgesehenen dekorativen Schicht, die durch ein PVD-Verfahren oder ein CVD-Verfahren abgelagert ist, vorzusehen, die eine ausgezeichnete Widerstandsfähigkeit gegen Zerkratzen und Abnutzung aufweisen sowie preisgünstig herzustellen sind und toxische Probleme weitestgehend vermeiden.

Zur Lösung dieser Aufgabe wird erfindungsgemäß ein Gegenstand gemäß Anspruch 1 vorgesehen. Im speziellen ist ein Gegenstand vorgesehen, der ein relativ weiches Trägermaterial, eine auf dem Trägermaterial aufgebrachte Haftschicht bzw. ein Haftschichtsystem und eine relativ harte dekorative Schicht umfasst,
wobei zwischen der Haftschicht und der dekorativen Schicht eine Zwischenschicht vorgesehen ist, die mindestens als Hauptbestandteil DLC enthält. Der Gegenstand ist dadurch gekennzeichnet dass die Haftschicht aus einer Metallschicht besteht, die mit abnehmendem Metall-Anteil und zunehmendem WC-Anteil in eine WC-Schicht übergeht, die anschließend mit einer W-C:H-Schicht versehen ist,
dass die Zwischenschicht mit dem Hauptbestandteil DLC jeweils auf der W-C:H-Schicht haftet, und
dass das Metall der Metallschicht aus der Gruppe Cr, Ti, Al, Zr, V oder Kombinationen davon ausgewählt ist.

Es ist nämlich erfindungsgemäß festgestellt worden, dass eine solche Zwischenschicht, deren Hauptbestandteil aus DLC besteht, deutlich härter ist als das relativ weiche Trägermaterial und im Vergleich zu einer Cr-Schicht in relativ kurzer Zeit und bei deutliche geringeren Materialkosten aufgebracht werden kann, aber dennoch im Stande ist, einen ausgezeichneten Widerstand gegen Zerkratzen und Abnutzung des Gegenstandes bzw. der darauf aufgebauten PVD- oder CVD-Schicht sicherzustellen, wobei auch nur relativ dünne PVD- oder CVD-Schichten im Bereich von 50 bis 500 nm erforderlich sind und ebenfalls relativ kostengünstig erzeugt werden können. Unter einem relativ weichen Trägermaterial ist unter anderem Metalle wie Aluminium, Messing, Zinkdruckguss oder Edelstahl zu verstehen, die beispielsweise in Form von Edelstahl eine Vickershärte HV_{0,025} von 250 aufweisen. Das weiche Trägermaterial weist im Regelfall einen HV_{0,025} Wert unterhalb von 300 auf, wobei dieser Wert nicht als eine Einschränkung verstanden werden soll, da auch Gegenstände aus Materialien mit einem höheren HV-Wert ebenfalls erfolgreich mit einer erfindungsgemäßen Schutzbeschichtung versehen werden können.

Gegenstände aus Kunststoffträgermaterialen haben im Allgemeinen einen HV_{0,025} Wert deutlich unterhalb von 250 HV_{0,025} und können ebenfalls erfolgreich mit einer erfindungsgemäßen Beschichtung versehen werden.

Bei einem Trägermaterial aus Edelstahl wäre als Beispiel ein Edelstahl mit 16 bis 18% Cr und 8 bis 12% Ni zu nennen, das nur ein Beispiel unter einer großen Vielfalt von Metallen darstellt.

Bei einem Trägermaterial aus Kunststoff könnten es sich um eine einzige Sorte Kunststoff oder um eine Mischung aus verschiedenen Kunststoffen handeln.

Der Kunststoff kann beispielsweise - ohne Einschränkung - aus der Gruppe bestehend aus ABS, Polycarbonat, PMMA, Polypropylen, Polystyren, Polyethylen, Polyamid, oder Kunstharz oder Mischungen der vorgenannten Kunststoffe einschließlich aus einem oder mehreren der vorgenannten Kunststoffe mit Faserverstärkung ausgewählt werden.

Eine Haftschicht oder ein Haftschichtsystem wird auf der gereinigten und/oder geätzten Oberfläche des Trägermaterial beim Herstellen des Gegenstands nach Anspruch 1 abgelagert, wobei die Zwischenschicht anschließend gegebenenfalls nach weiterem Reinigen und/oder Ätzen auf die freie Oberfläche der Haftschicht oder des Haftschichtsystems abgeschieden wird.

Bei einer bevorzugten Ausführungsform des erfindungsgemäßen Gegenstands bzw. Verfahrens, das sich bestens für ein Trägermaterial aus Edelstahl aber auch für Kunststoffflächen eignet, besteht die Haftschicht aus einer Cr-Schicht, die mit abnehmendem Cr-Anteil und zunehmendem WC-Anteil in eine WC-Schicht übergeht, die anschließend mit einer W-C:H-Schicht versehen ist, auf der die Zwischenschicht mit DLC als Hauptbestandteil haftet. Die Haftschicht aus Cr wird aber im Gegensatz zum Stand der Technik nicht galvanisch aufgebracht, sondern mittels eines PVD-Verfahrens. Somit entstehen keine Probleme, die auf Chrom-VI zurückzuführen sind. Ferner ist die so aufgebrachte Cr-Schicht relativ dünn, beispielsweise unter 50 nm, so dass die Behandlungszeit in der Vakuumkammer der PVD-Anlage relativ kurz ist, was das Herstellungsverfahren, das chargenweise durchgeführt wird, wesentlich kostengünstiger gestaltet und auch der Gebrauch von Chrom gesenkt wird und daher auch aus diesem Grund die Herstellungskosten sinken.

Anstelle einer Haftschicht aus reinem Chrom kommt auch eine Schicht aus CrN in Frage, beispielsweise eine Schicht, die als Gradientenschicht realisiert wird, bei der der Chrom-Anteil mit zunehmender Schichtdicke zu Gunsten eines zunehmenden N-Anteils reduziert wird. Hierdurch kann der Verbrauch an Cr weiter gesenkt werden und die Schicht wird durch den eingebauten Stickstoff gleichzeitig deutlich härter.

Bei einer weiteren Ausführung des erfindungsgemäßen Gegenstands bzw. Verfahrens besteht die Haftschicht aus einer Ti-Schicht, die mit abnehmendem Ti-Anteil und zunehmendem WC-Anteil in eine WC-Schicht übergeht, die anschließend mit einer W-C:H-Schicht versehen ist, auf der die Zwischenschicht mit DLC als Hauptbestandteil haftet. Auch hier käme eine TiN-Haftschicht anstelle einer reinen Ti-Haftschicht in Frage.

Ferner besteht die Möglichkeit, polymere Haftschichtsysteme anzuwenden, die an sich bekannt sind und in einem PAVCD-Verfahren auf das Trägermaterial aufgebracht werden können unter Anwendung von Organosilizium-Verbindungen, die in die entsprechende Vakuumanlage in Gas- oder Flüssigform eingeführt werden. Ein Beispiel ist HDSMO (hexadimethyldisiloxane), das im Plasma durch Cracken in silizium- und kohlenwasserstoffhaltige Verbindungen überführt wird, die als eine Polymerschicht auf den Gegenstand abgelagert werden, die die Haftschicht bildet. Durch Steigerung des Sauerstoffanteils in der Gasatmosphäre der Anlage kann diese gut haftende, aber etwas weiche Schicht vorteilhaft in Richtung einer aus SiO₂ bestehenden glasartigen Schicht verändert werden, was eine vorteilhafte deutliche Steigerung der Schichthärte bedeutet.

Es bestehen eine Vielzahl von Möglichkeiten, dekorative Schichten zu realisieren, die auf der freien Oberfläche der Zwischenschicht aufzubringen sind, von denen einige Beispiele - ohne Einschränkung - nachfolgend näher angegeben werden. Beispielsweise kann erfindungsgemäß die mittels PVD und/oder CVD aufgebrachte dekorative Schicht eine schwarze Schicht aus nicht reaktiv aufgebrachtem Ti mit einer reaktiv angebrachten Beschichtung aus TiCrCN umfassen.

Nach einer weiteren erfindungsgemäßen Alternative kann die dekorative Schicht eine mittels PVD abgelagerte ZrCN-Schicht mit einer Messing-, Gold-, Nickel- oder Bronzefarbe sein.

Nach einer anderen erfindungsgemäßen Alternative kann die dekorative Schicht eine TiCN-Schicht mit einer Gold-, Edelstahl-, Bronze oder Kupferfarbe sein.

Eine noch weitere erfindungsgemäße Alternative besteht darin, die dekorative Schicht durch eine mittels PVD abgelagerte CrCN-Schicht mit einer Edelstahlfarbe zu realisieren.

Ferner besteht erfindungsgemäß die Möglichkeit, die dekorative Schicht durch eine mittels PVD abgelagerte ZrCrCN-Schicht mit einer Anthrazitfarbe zu realisieren.

Weiterhin besteht die Möglichkeit als dekorative Schichten farbgebende Oxid- oder Oxinitridschichten, die mittels PVD-Verfahren abgelagert werden, zu verwenden, die Regenbogenfarben wie blau, grün usw. aufweisen. Solche Schichten bestehen bspw. aus TiCrO, TiCrON, TiON, CrON.

Bei solchen dekorativen Schichten werden üblicherweise Schichtdicken von etwa 50 bis 500 nm verwendet.

Das erfindungsgemäße Verfahren, das in den Ansprüchen 15 bis 28 näher beschrieben ist, wird vorzugsweise in einer Anlage mit mindestens einem Sputtertarget für die Ablagerung einer etwaigen Haftschicht bzw. eines etwaigen Haftschichtsystems und/oder Bestandteile der dekorativen Schicht, mit einem PACVD-System zur Anbringung der Zwischenschicht mit DLC als Haupt- oder ausschließliches Bestandteil und mit mindestens einer Lichtbogenquelle für die Anbringung einer etwaigen Haftschicht bzw. eines etwaigen Haftschichtsystems und/oder Bestandteile der dekorativen Schicht, durchgeführt wird.

Die Erfindung wird nunmehr nachfolgend anhand von Ausführungsbeispiele und der Zeichnung, in welcher:
- Fig. 1: einen Querschnitt durch einen Gegenstand und die auf diesem Gegenstand aufgebrachten Schichten zeigt,
- Fig. 2: einen Querschnitt durch einen weiteren erfindungsgemäßen Gegenstand und die auf diesem Gegenstand aufgebrachten Schichten zeigt und
- Fig. 3 und 4: zwei weitere Beispiele von Schichtsystemen, die erfindungsgemäß auf Trägermaterialien aus Kunststoff (oder Metall) verwendet werden können.

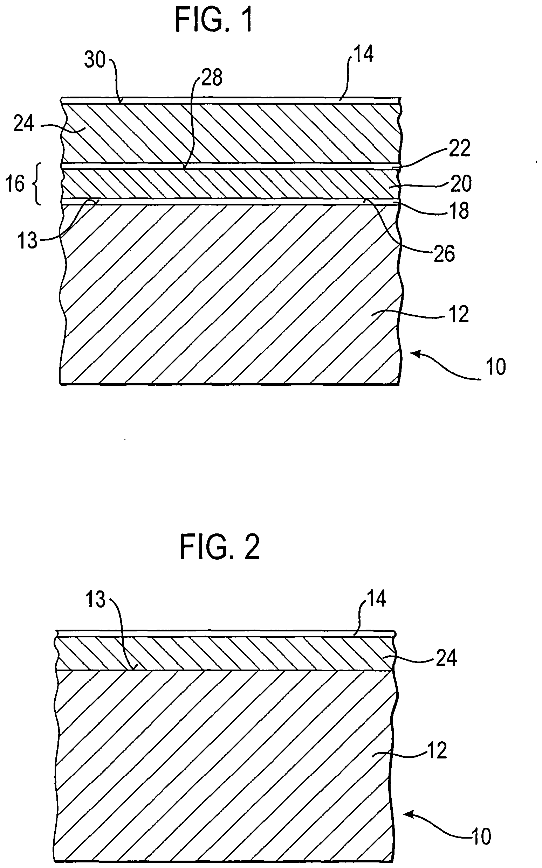

Fig. 1 zeigt zunächst einen Querschnitt durch einen Gegenstand 10 beliebiger Art, der aus einem Trägermaterial 12 und einer dekorativen Beschichtung 14 besteht. Auf der ursprünglich freien Oberfläche 13 des Trägermaterials 12 des Gegenstands befindet sich in diesem Beispiel ein Haftschichtsystem 16, das aus einer Grundschicht 18, einer Übergangsschicht 20 und einer Deckschicht 22 besteht.

Zwischen der Deckschicht 22 und der dekorativen Schicht 14 befindet sich eine Zwischenschicht 24, die in diesem Beispiel eine DLC-Schicht ist, d.h. eine Schicht, die bis auf Verunreinigungen, die möglichst vermieden werden sollten, aus DLC (Diamond-Like Carbon) besteht.

Die einzelnen Bestandteile dieses Beispiels werden nunmehr näher beschrieben.

Bei dem Trägermaterial 12 handelt es sich in diesem Beispiel entweder um ein Metall, wie beispielsweise Edelstahl, oder um einen Kunststoff, wie beispielsweise ABS. Edelstahl weist eine Vickershärte von 250 HV_{0,025} auf und gilt demnach als relativ weich. Insbesondere befasst sich die vorliegende Erfindung mit relativ weichen Trägermaterialien mit Härten, die üblicherweise unter 300 HV_{0,025} liegen, wobei aber die Erfindung auch mit härteren Trägermaterialien verwendet werden kann und diese Härteangaben nicht als Einschränkung zu verstehen sind.

Wenn das Trägermaterial 12 des Gegenstandes 10 aus Kunststoff realisiert ist, beispielsweise ABS, so liegt die Vickershärte deutlich unter 250 HV_{0,025}.

Für die Anbringung der Schichten 18, 20, 22, 24 und 14 wird der Gegenstand 10 in eine flexible Vakuumbeschichtungsanlage eingesetzt, die vorzugsweise im Stande ist, Beschichtungen durch Magnetron-Zerstäubung und durch PACVD (Plasma Assisted Chemical Vapour Deposition) anzubringen, wobei die Anlage vorzugsweise auch im Stande sein soll, Beschichtungen mittels Lichtbogenverdampfung unter Anwendung von Arc-Quellen ebenfalls auf Gegenstände durch entsprechende PVD-Verfahren anzubringen. Eine solche Anlage könnte beispielsweise eine Hauzer Flexicoat-Anlage sein, die mit einem PACVD-System ergänzt ist. Hauzer Flexicoat-Anlagen sind bspw. durch das europäische Patent EP-403552 geschützt.

Nach dem Einführen des Gegenstandes 10 in die flexible Vakuumbeschichtungsanlage wird bei gleichzeitiger Evakuierung der Kammer der Gegenstand zunächst durch Aufheizung der Anlage in an sich bekannter Weise auf Betriebstemperatur aufgeheizt, wodurch flüchtige Bestandteile, die als Verunreinigungen im Gegenstand zu verstehen sind, weitestgehend von diesem entfernt werden. Sie werden über das Vakuumsystem der flexiblen Vakuumbeschichtungsanlage abgesaugt. Nach dem Erreichen der angebrachten Betriebstemperatur, die für Kunststoffe und Metalle unterschiedlich ist, aber an sich in der Praxis materialspezifisch gut bekannt ist, werden zunächst die Targets, d.h. die Zerstäubungskathoden, die die Materialien für die Schichten 18, 20, 22 und 14 liefern, gereinigt, Dies erfolgt beispielsweise dadurch, dass die Targets im Sputterbetrieb und mit einer Inertgasatmosphäre in der flexiblen Vakuumbeschichtungsanlage mit geschlossenem Shutter betrieben werden, wodurch das gesputterte, zunächst kontaminierte Oberflächenmaterial der Targets auf den Shutter abgeschieden wird. Hierdurch werden die Verunreinigungen auf den Oberflächen der Targets, beispielsweise Verunreinigungen aus einem früheren Beschichtungsvorgang, entfernt, so dass die Targets die erforderliche Reinheit aufweisen. Danach wird über einen weiteren Zeitraum ein Ätzverfahren unter Anwendung einer Plasmaquelle durchgeführt, die in der flexiblen Vakuumbeschichtungsanlage eingebaut ist. Solche Plasmaquellen sind an sich gut bekannt und werden häufig im Puls-Betrieb betrieben, da dies praktische Vorteile bringt. Während dieses Ätzverfahrens wird die freie Oberfläche 13 des Trägermaterials 12 geätzt und gereinigt, um eine gute Haftung des Haftschichtsystems 16 zu erreichen.

Nach der Reinigung der Oberfläche 13 wird die dünne Schicht 18 aus Cr mit einer Dicke im Bereich von 50 bis 500 nm auf die Oberfläche des Gegenstands 10 durch PVD abgelagert. Dies ist bei einem Gegenstand aus Edelstahl vorteilhaft, da Cr ohnehin im Edelstahl enthalten ist, und es wird auf diese Weise ein qualitativ hochwertiger Übergang zwischen dem Trägermaterial 12 und der Haftschicht 18 sichergestellt, was der Haftung zugute kommt.

Bei einem Gegenstand aus Kunststoff bietet die Anbringung der Cr-Schicht die Möglichkeit, eine leitende Schicht auf dem Kunststoffgegenstand zu erreichen, die für das weitere Verfahren nützlich ist. Die Anbringung einer Cr-Schicht auf einem Kunststoffgegenstand ist beispielsweise in der EP-Patentschrift 1116801 beschrieben.

Diese Cr-Schicht 18 kann durch ein magnetisches Zerstäubungsverfahren von einer Sputterquelle, d.h. Target aus Cr, erfolgen oder könnte mit einem Lichtbogenbeschichtungsverfahren von einem entsprechenden Target als Arc-Quelle erfolgen.

Die Übergangsschicht 20 besteht aus einer Mischung aus Cr und WC, wobei der Cr-Anteil von einem maximalen Wert an der Oberfläche der Schicht 18 in Richtung der Grenzfläche 28 gehend allmählich auf Null reduziert wird, während der Anteil an WC zunehmend erhöht wird, so dass an der freien Oberfläche der Übergangsschicht 20 zumindest im Wesentlichen kein Cr mehr vorhanden ist und die freie Oberfläche im Wesentlichen aus einer WC-Schicht besteht. Diese Übergangsschicht 20 ist ebenfalls relativ dünn, jedoch dicker als die Haftschicht 18 und wird mit der Deckschicht 22 abgeschlossen, die in diesem Beispiel eine W-C:H-Schicht darstellt.

WC für die Übergangsschicht 20 wird von einem Target aus WC erzeugt, das als Sputterquelle betrieben wird.

Um die Deckschicht 22 aus W-C:H zu erzeugen, wird die bisherige Atmosphäre der flexiblen Vakuumbeschichtungsanlage aus Argon durch die Zufuhr von Acetylen C₂H₂ teilweise ersetzt und dies führt dazu, dass die WC-Schicht jetzt einen Oberschuss an Kohlenstoff enthält und durch den vorhandenen Wasserstoff modifiziert wird. Es entsteht daher eine so genannte W-C:H-Schicht. Nach Erzeugung der ebenfalls sehr dünnen Deckschicht 22 wird der Betriebsmodus der flexiblen Vakuumbeschichtungsanlage auf PAVCD umgeschaltet, und es wird dann in an sich bekannter Weise eine DLC-Schicht 24 erzeugt, die beispielsweise ca. 2 µm dick sein kann. Diese Dickenangabe stellt aber keinerlei Beschränkung der Erfindung dar - die Schicht könnte auch dünner oder dicker sein, ohne den Umfang der erfindungsgemäßen Lehre zu verlassen.

In diesem Beispiel besteht die Zwischenschicht 24 ausschließlich aus DLC (bis auf die üblichen unvermeidbaren Verunreinigungen) und wird aus den zugeführten Acetylen, d.h. aus der Atmosphäre der flexiblen Vakuumbeschichtungsanlage erzeugt.

Obwohl es sich in diesem Beispiel bei der Zwischenschicht 24 um reines DLC handelt, ist es durchaus denkbar, dass DLC nur einen Bestandteil der Zwischenschicht 24 bildet. Beispielsweise könnten andere Bestandteile, wie beispielsweise Silizium mit abgeschieden werden, das im Regelfall aus einer Gasatmosphäre der Anlage stammt, aber auch von einem entsprechenden Target entweder durch ein Magnetron-Zerstäubungsverfahren oder durch ein Lichtbogenverfahren stammen könnte. Üblicherweise bildet DLC den Hauptbestandteil der Zwischenschicht 24.

Schließlich wird eine dünnere dekorative Schicht 14 von beispielsweise 50 bis 500 nm Dicke auf die freie Oberfläche 30 der Zwischenschicht 24 abgeschieden. Es könnte sich bei der dekorativen Schicht 14 um eine beliebige dekorative Schicht handeln, die mittels eines PVD- oder CVD-Verfahrens abgeschieden werden kann. Beispiele für solche Schichten und die damit erzeugbaren Farben sind im Stand der Technik hinlänglich bekannt und einige erfindungsgemäß bevorzugte Beschichtungen sind in den Patentansprüchen 10 bis 13 angegeben.

Bei dem Beispiel des Anspruchs 10 wird eine TiCrCN-Beschichtung aufgebracht, und zwar mit einer ersten Schicht Ti, die bei einer nicht reaktiven Arbeitsweise abgeschieden wird, und zwar entweder durch Magnetron-Sputtering von einem entsprechenden Ti-Target oder durch ein Lichtbogenverfahren von einem entsprechenden Target, ohne dass eine chemische Reaktion mit der Atmosphäre der Kammer stattfindet. Zu diesem Zweck muss die Atmosphäre der Kammer durch ein Inertgas gebildet werden, wie beispielsweise Ar.

Schließlich wird die TiCrCN-Schicht erzeugt. Zu diesem Zweck werden Targets aus Ti und Cr verwendet und die Atmosphäre der Kammer wird geändert, sodass sie durch Gase gebildet werden, die Kohlenstoff und Stickstoff liefern, beispielsweise aus einer Mischung aus Acetylen und Stickstoff.

Die Anbringung der weiteren Beschichtungen der Ansprüche 11 bis 14 erfolgt analog, nur ist es bei den dort angegebenen Schichten nicht erforderlich, zuerst eine metallische Schicht aus Ti mit einem nicht reaktiven Verfahren abzulagern, sondern die entsprechenden Verbindungen können reaktiv von entsprechenden Targets und Gasen erzeugt werden.

Es ist nicht zwingend erforderlich, ein Haftschichtsystem wie 16 zu verwenden, sondern man kann nicht nur dieses Haftschichtsystem vollständig weglassen, wenn eine ausreichende Haftung durch die Vorbereitung der Oberfläche des Gegenstands (Reinigen und/oder Ätzen) erreicht werden kann oder es kann eine einzelne Haftschicht aus einem geeigneten Material anstelle des Haftschichtsystems verwendet werden.

Bei der Ausführungsform gemäß Fig. 2 wird eine Struktur erzeugt, die der der Fig. 1 sehr ähnlich ist, nur wird hier das Haftschichtsystem 16 weggelassen, d.h. die Zwischenschicht 24 wird unmittelbar auf die freie Oberfläche 13 des Gegenstands abgelagert und wird auch unmittelbar von der dekorativen Schicht 14 gefolgt.

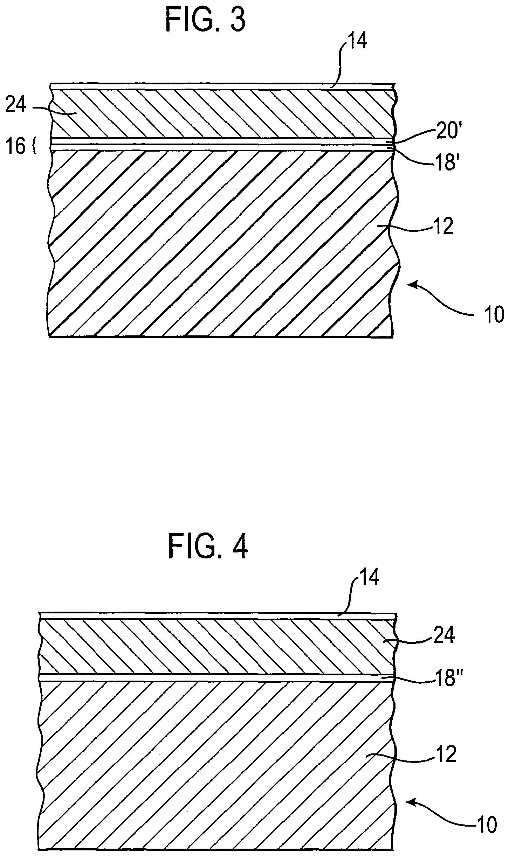

Bei der Darstellung gemäß Fig. 3 wird ein Gegenstand 10 aus Kunststoff gezeigt, der ein Haftschichtsystem 16 bestehend aus den hier galvanisch aufgebrachten Schichten 18' und 20' aufweist, wobei die Schicht 18' aus Cu und die Schicht 20' aus Ni besteht.

Ferner ist in Fig. 4 ein Gegenstand gezeigt mit einer Haftschicht 18", die aus einer Polymerschicht besteht, beispielsweise aus einer PolymerSchicht, die wie oben erläutert aus HDMSO mittels eines PACVD-Verfahrens erzeugt wird.

In den Darstellungen gemäß Fig. 2, 3 und 4 werden die gleichen Bezugszeichen wie in Fig. 1 verwendet und die entsprechenden Erläuterungen gelten genauso für die Bestandteile dieser Figuren und werden hier nicht wiederholt.

## Patentansprüche

1. Gegenstand (10), der ein relativ weiches Trägermaterial (12), eine auf dem Trägermaterial aufgebrachte Haftschicht (18) bzw. ein Haftschichtsystem (16) und eine relativ harte dekorative Schicht (14) umfasst,
wobei zwischen der Haftschicht (18) und der dekorativen Schicht (14) eine Zwischenschicht (24) vorgesehen ist, die mindestens als Hauptbestandteil DLC enthält
**dadurch gekennzeichnet,**
**dass** die Haftschicht (18) aus einer Metallschicht oder einer CrN-Schicht besteht, die mit abnehmendem Metall- bzw. CrN-Anteil und zunehmendem WC-Anteil in eine WC-Schicht übergeht, die anschließend mit einer W-C:H-Schicht versehen ist,
**dass** die Zwischenschicht (24) mit dem Hauptbestandteil DLC jeweils auf der W-C:H-Schicht haftet, und
**dass** das Metall der Metallschicht aus der Gruppe Cr, Ti, Al, Zr, V oder Kombinationen davon ausgewählt ist.

2. Gegenstand nach Anspruch 1,
**dadurch gekennzeichnet,**
**dass** das Trägermaterial aus einem Kunststoff besteht und insbesondere aus der Gruppe bestehend aus ABS, Polycarbonat, PMMA, Polypropylen, Polystyren, Polyethylen, Polyamid, oder Kunstharz oder Mischungen der vorgenannten Kunststoffen einschließlich aus einem oder mehreren der vorgenannten Kunststoffen mit Faserverstärkung ausgewählt ist, oder aus einem Metall oder einer Metalllegierung besteht und zum Beispiel aus der Gruppe bestehend aus Aluminium, Messing, Magnesium und Edelstahl ausgewählt ist und insbesondere ein Edelstahl mit 16 bis 18% Cr und 8 bis 12% Ni ist.

3. Gegenstand nach einem der vorhergehenden Ansprüche,
**dadurch gekennzeichnet,**
**dass** die Haftschicht aus einer Cr-Schicht besteht, die mit abnehmendem Cr-Anteil und zunehmendem WC-Anteil in eine WC-Schicht übergeht, die anschließend mit einer W-C:H-Schicht versehen ist,

4. Gegenstand nach einem der Ansprüche 1 oder 2,
**dadurch gekennzeichnet, dass** die Haftschicht (18) aus einer CrN-Schicht besteht ggf. in Form einer gradierten CrN-Schicht mit abnehmendem Cr-Anteil und steigendem N-Anteil, die graduell in eine WC-Schicht übergeht, wobei der Anteil WC in Richtung von der CrN-Schicht weg ansteigt und die WC-Schicht anschließend mit einer W-C:H-Schicht versehen ist.

5. Gegenstand nach einem der Ansprüche 1 oder 2,
**dadurch gekennzeichnet,**
**dass** die Haftschicht aus einer Ti-Schicht besteht, die mit abnehmendem Ti-Anteil und zunehmendem WC-Anteil in eine WC-Schicht übergeht, die anschließend mit einer W-C:H-Schicht versehen ist.

6. Gegenstand nach einem der vorhergehenden Ansprüche,
dadurch geke nnze ichnet,
dass die mittels PVD und/oder CVD aufgebrachte dekorative Schicht entweder eine schwarze Schicht aus nicht reaktiv aufgebrachtem Ti mit einer reaktiv angebrachten Beschichtung aus TiCrCN umfasst, oder eine mittels PVD abgelagerte ZrCN-Schicht mit einer Messing-, Gold-, Nickel- oder Bronzefarbe ist, oder eine TiCN-Schicht mit einer Gold-, Edelstahl-, Bronze oder Kupferfarbe ist, oder eine mittels PVD abgelagerte CrCN-Schicht mit einer Edelstahlfarbe ist, oder eine mittels PVD abgelagerte ZrCrCN-Schicht mit einer Anthrazitfarbe ist, oder eine mittels PVD abgelagerte Oxid- oder Oxinitridschicht mit einer Regenbogenfarbe wie blau oder grün ist, wobei die Oxid- oder Oxidnitridschicht insbesondere durch ein Oxid oder Oxinitrid eines Metalls der Gruppe Ti, Cr, oder einer Kombination dieser Metalle gebildet ist.

7. Verfahren zur Herstellung eines Gegenstands, der ein relativ weiches Trägermaterial (12), eine auf dem Trägermaterial aufgebrachte Haftschicht (18) bzw. ein Haftschichtsystem (16) und eine relativ harte dekorative Schicht (14) umfasst,
wobei zwischen der Haftschicht (18) bzw. dem Haftschichtsystem (16) und der relativ harten dekorativen Schicht (14) eine Zwischenschicht (24) vorgesehen wird, die mindestens als Hauptbestandteil DLC enthält
**dadurch gekennzeichnet,**
**dass** als Haftschicht eine Metallschicht oder eine CrN-Schicht angebracht wird, die mit abnehmendem Metall- bzw. CrN-Anteil und zunehmendem WC-Anteil in eine WC-Schicht übergeht, die anschließend mit einer W-C:H-Schicht versehen wird, wobei die Zwischenschicht (24) mit dem Hauptbestandteil DLC jeweils auf die W-C:H-Schicht aufgebracht wird, und dass das Metall der Metallschicht aus der Gruppe Cr, Ti, Al, Zr, V oder Kombinationen davon ausgewählt ist.

8. Verfahren nach Anspruch 7,
dadurch **gekennezeichnet**,
dass das Trägermaterial aus einem Kunststoff besteht und insbesondere aus der Gruppe bestehend aus ABS, Polycarbonat, PMMA, Polypropylen, Polystyren, Polyethylen, Polyamid, oder Kunstharz oder Mischungen der vorgenannten Kunststoffen einschließlich aus einem oder mehreren der vorgenannten Kunststoffen mit Faserverstärkung ausgewählt wird, oder aus einem Metall oder einer Metalllegierung ausgewählt wird, zum Beispiel aus der Gruppe bestehend aus Aluminium, Messing, Magnesium und Edelstahl ausgewählt wird und insbesondere ein Edelstahl mit 16 bis 18% Cr und 8 bis 12% Ni ist.

9. Verfahren nach Anspruch 7 oder 8,
**dadurch gekennzeichnet,**
**dass** als Haftschicht eine Cr-Schicht angebracht wird, die mit abnehmendem Cr-Anteil und zunehmendem WC-Anteil in eine WC-Schicht übergeht, die anschließend mit einer W-C:H-Schicht versehen wird, oder als Haftschicht eine CrN-Schicht angebracht wird ggf. in Form einer gradierten CrN-Schicht mit abnehmendem Cr-Anteil und steigendem N-Anteil, die graduell in eine WC-Schicht übergeht, wobei der Anteil WC in Richtung von der CrN-Schicht weg ansteigt und die WC-Schicht anschließend mit einer W-C:H-Schicht versehen wird, oder als Haftschicht eine Ti-Schicht angebracht wird, die mit abnehmendem Ti-Anteil und zunehmendem WC-Anteil in eine WC-Schicht übergeht, die anschließend mit einer W-C:H-Schicht versehen wird.

10. Verfahren nach einem der vorhergehenden Ansprüche 7 bis 9,
**dadurch gekennzeichnet,**
**dass** die mittels PVD und/oder CVD aufgebrachte dekorative Schicht entweder eine schwarze Schicht aus nicht reaktiv aufgebrachtem Ti mit einer reaktiv angebrachten Beschichtung aus TiCrCN umfasst, oder eine mittels PVD abgelagerte ZrCN-Schicht mit einer Messing-, Gold-, Nickel- oder Bronzefarbe ist, oder eine TiCN-Schicht mit einer Gold-, Edelstahl-, Bronze oder Kupferfarbe ist, oder eine mittels PVD abgelagerte CrCN-Schicht mit einer Edelstahlfarbe ist, oder eine mittels PVD abgelagerte ZrCrCN-Schicht mit einer Anthrazitfarbe ist, oder eine mittels PVD abgelagerte Oxid- oder Oxinitridschicht mit einer Regenbogenfarbe wie blau oder grün ist, wobei die Oxid- oder Oxidnitridschicht insbesondere durch ein Oxid oder Oxinitrid eines Metalls der Gruppe Ti, Cr, oder einer Kombination dieser Metalle gebildet wird.

11. Verfahren nach einem der Ansprüche 7 bis 10,
**dadurch gekennzeichnet,**
**dass** es in einer Anlage mit mindestens einem Sputtertarget für die Ablagerung einer etwaigen Haftschicht bzw. eines etwaigen Haftschichtsystems und/oder Bestandteile der dekorativen Schicht, mit einem PACVD-System zur Anbringung der Zwischenschicht mit DLC als Haupt- oder ausschließliches Bestandteil und mit mindestens einer Lichtbogenquelle für die Anbringung einer etwaigen Haftschicht bzw. eines etwaigen Haftschichtsystems und/oder Bestandteile der dekorativen Schicht, durchgeführt wird.

12. Anlage zur Durchführung eines Verfahrens nach einem der vorhergehenden Anspruche 7 bis 11,
**gekennzeichnet durch** die Kombination in einer Vakuumkammer von mindestens einem Magnetron-Sputtersystem mit mindestens einem Sputtertarget, einem PACVD-System und einem Lichtbogenverdampfungssystem mit mindestens einer Arcquelle.

## Claims

1. An article (10) which comprises a relatively soft support material (12), a bond layer (18) or a bond layer system (16) applied to the support material and a relatively hard decorative layer (14),
wherein an intermediate layer (24) which contains DLC, at least as a main component, is provided between the bond layer (18) and the decorative layer (14),
**characterized in that**
the bond layer (18) consists of a metal layer or a CrN layer which merges with a reducing proportion of metal or a reducing proportion of CrN and an increasing proportion of WC into a WC layer which is subsequently provided with a W-C:H layer;
**in that** the intermediate layer (24) with the main component DLC bonds on the respective W-C:H layer; and
**in that** the metal of the metal layer is selected from the group Cr, Ti, Al, Zr, V or combinations thereof.

2. An article in accordance with claim 1,
**characterized in that**
the support material consists of a plastic and is in particular selected from the group consisting of ABS, polycarbonate, PMMA, polypropylene, polystyrene, polyethylene, polyamide or synthetic resin or mixtures of the above-named plastics including one or more of the above-named plastics with fiber reinforcement or consists of a metal or a metal alloy and is, for example, selected from the group consisting of aluminum, brass, magnesium and stainless steel and is in particular a stainless steel with 16 to 18% Cr and 8 to 12% Ni.

3. An article in accordance with one of the preceding claims,
**characterized in that**
the bond layer consists of a Cr layer which merges with a reducing proportion of Cr and an increasing proportion of WC into a WC layer which is subsequently provided with a W-C:H layer.

4. An article in accordance with one of the claims 1 or 2,
**characterized in that**
the bond layer (18) consists of a CrN layer, optionally in the form of a gradient CrN layer with a reducing proportion of Cr and an increasing proportion of N, which gradually merges into a WC layer, with the proportion of WC increasing in the direction away from the CrN layer and the WC layer subsequently being provided with a W-C:H layer.

5. An article in accordance with one of the claims 1 or 2,
**characterized in that**
the bond layer consists of a Ti layer which merges with a reducing proportion of Ti and an increasing proportion of WC into a WC layer which is subsequently provided with a W-C:H layer.

6. An article in accordance with any one of the preceding claims,
**characterized in that**
the decorative layer applied by means of PVD and/or CVD either comprises a black layer of non-reactively applied Ti with a reactively attached coating of TiCrCN or it is a ZrCN layer deposited by means of PVD with a brass, gold, nickel or bronze color, or a TiCN layer with a gold, stainless steel, bronze or copper color, or a CrCN layer deposited by means of PVD with a stainless steel color, or a ZrCrCN layer deposited by means of PVD with an anthracite color, or an oxide or oxynitride layer deposited by means of PVD having a rainbow color such as blue or green, with the oxide or oxynitride layer in particular being formed by an oxide or oxynitride of a metal of the group Ti, Cr or a combination of these metals.

7. A method for the manufacture of an article which comprises a relatively soft support material (12), a bond layer (18) or a bond layer system (16) applied to the support material and a relatively hard decorative layer (14),
wherein an intermediate layer (24) which contains DLC, at least as a main component, is provided between the bond layer (18) or the bond layer system (16) and the relatively hard decorative layer (14),
**characterized in that**
a metal layer or a CrN layer is applied as the bond layer and merges with a reducing proportion of metal or a reducing proportion of CrN and an increasing proportion of WC into a WC layer which is subsequently provided with a W-C:H layer, with the intermediate layer (24) with the main component DLC being applied to the respective W-C:H layer; and **in that** the metal of the metal layer is selected from the group Cr, Ti, Al, Zr, V or combinations thereof.

8. A method in accordance with claim 7,
**characterized in that**
the support material consists of a plastic and is in particular selected from the group consisting of ABS, polycarbonate, PMMA, polypropylene, polystyrene, polyethylene, polyamide or synthetic resin or mixtures of the above-named plastics including one or more of the above-named plastics with fiber reinforcement or is selected from a metal or a metal alloy, for example, is selected from the group consisting of aluminum, brass, magnesium and stainless steel and is in particular a stainless steel with 16 to 18% Cr and 8 to 12% Ni.

9. A method in accordance with claim 7 or claim 8,
**characterized in that**
a Cr layer is applied as the bond layer and merges with a reducing proportion of Cr and an increasing proportion of WC into a WC layer which is subsequently provided with a W-C:H layer; or **in that** a CrN layer is applied as the bond layer, optionally in the form of a gradient CrN layer with a reducing proportion of Cr and an increasing proportion of N, and gradually merges into a WC layer, with the proportion of WC increasing in the direction away from the CrN layer and the WC layer subsequently being provided with a W-C:H layer; or **in that** a Ti layer is applied as the bond layer and merges with a reducing proportion of Ti and an increasing proportion of WC into a WC layer which is subsequently provided with a W-C:H layer.

10. A method in accordance with any one of the preceding claims 7 to 9,
**characterized in that**
the decorative layer applied by means of PVD and/or CVD either comprises a black layer of non-reactively applied Ti with a reactively attached coating of TiCrCN or it is a ZrCN layer deposited by means of PVD with a brass, gold, nickel or bronze color, or a TiCN layer with a gold, stainless steel, bronze or copper color, or a CrCN layer deposited by means of PVD with a stainless steel color, or a ZrCrCN layer deposited by means of PVD with an anthracite color, or an oxide or oxynitride layer deposited by means of PVD having a rainbow color such as blue or green, with the oxide or oxynitride layer in particular being formed by an oxide or oxynitride of a metal of the group Ti, Cr or a combination of these metals.

11. A method in accordance with any one of the claims 7 to 10,
**characterized in that**
it is carried out in a plant having at least one sputter target for the deposition of any bond layer or of any bond layer system and/or components of the decorative layer, a PACVD system for the application of the intermediate layer with DLC as the main component or exclusive component, and at least one arc source for the application of any bond layer or of any bond layer system and/or components of the decorative layer.

12. A plant for carrying out a method in accordance with any one of the preceding claims 7 to 11,
**characterized by** the combination in a vacuum chamber of at least one magnetron sputter system with at least one sputter target, a PACVD system and an arc vaporization system having at least one arc source.

## Revendications

1. Objet (10) comportant un matériau porteur (12) relativement souple, une couche adhésive (18) déposée sur le matériau porteur ou un système à couche adhésive (16), et une couche décorative (14) relativement dure, dans lequel une couche intermédiaire (24) est prévue entre la couche adhésive (18) et la couche décorative (14), qui contient au moins comme constituant principal du DLC,
**caractérisé en ce que**
la couche adhésive (18) est constituée par une couche en métal ou par une couche en CrN qui, en présentant une part de métal ou de CrN décroissant et une part de WC croissant, se transforme en une couche en WC qui est ensuite pourvue d'une couche en W-C:H,
**en ce que** la couche intermédiaire (24) avec le constituant principal DLC adhère respectivement sur la couche en W-C:H, et
**en ce que** le métal de la couche en métal est choisi parmi le groupe comprenant Cr, Ti, Al, Zr, V ou des combinaisons de ceux-ci.

2. Objet selon la revendication 1,
**caractérisé en ce que**
le matériau porteur est constitué en une matière plastique et est choisi en particulier parmi le groupe comprenant ABS, polycarbonate, PMMA, polypropylène, polystyrène, polyéthylène, polyamide ou de la résine synthétique ou des mélanges desdites matières plastiques, y compris une ou plusieurs desdites matières plastiques avec renforcement de fibres, ou il est constitué en un métal ou en un alliage de métal et choisi par exemple parmi le groupe comprenant aluminium, laiton, magnésium et acier inoxydable, et il est en particulier un acier inoxydable avec 16 à 18 % de Cr et 8 à 12 % de Ni.

3. Objet selon l'une des revendications précédentes,
**caractérisé en ce que**
la couche adhésive est constituée en une couche en Cr qui, en présentant une part de Cr décroissant et une part de WC croissant, se transforme en une couche en WC qui est ensuite pourvue d'une couche en W-C:H.

4. Objet selon l'une des revendications 1 ou 2,
**caractérisé en ce que**
la couche adhésive (18) est constituée en une couche en CrN le cas échéant sous la forme d'une couche en CrN graduée avec une part de Cr décroissant et avec une part de N croissant, qui se transforme graduellement en une couche en WC, la part de WC croissant en direction depuis la couche en CrN et la couche en WC est ensuite pourvue d'une couche en W-C:H.

5. Objet selon l'une des revendications 1 ou 2,
**caractérisé en ce que**
la couche adhésive est constituée en une couche en Ti qui, en présentant une part de Ti décroissant et une part de WC croissant, se transforme en une couche en WC qui est ensuite pourvue d'une couche en W-C:H.

6. Objet selon l'une des revendications précédentes,
**caractérisé en ce que**
la couche décorative déposée par PVD et/ou par CVD est soit une couche noire en Ti déposé par voie non réactive avec un revêtement en TiCrCN déposé par voie réactive, soit une couche en ZrCN déposée par PVD avec une couleur de laiton, d'or, de nickel ou de bronze, soit encore une couche en TiCN avec une couleur d'or, d'acier inoxydable, de bronze ou de cuivre, soit encore une couche en CrCN déposée par PVD avec une couleur d'acier inoxydable, soit encore une couche en ZrCrCN déposée par PVD avec une couleur d'anthracite, soit encore une couche en oxyde ou en oxynitrure déposée par PVD avec une couleur d'arc en ciel, telle que le bleu ou le vert, la couche d'oxyde ou d'oxynitrure étant formée en particulier par un oxyde ou un oxynitrure d'un métal parmi le groupe comprenant Ti, Cr, soit encore une combinaison de ces métaux.

7. Procédé pour fabriquer un objet comportant un matériau porteur (12) relativement souple, une couche adhésive (18) déposée sur le matériau porteur ou un système à couche adhésive (16), et une couche décorative (14) relativement dure,
dans lequel une couche intermédiaire (24) est prévue entre la couche adhésive (18) ou le système à couche adhésive (16) et la couche décorative (14) relativement dure, qui contient au moins comme constituant principal du DLC,
**caractérisé en ce que**
en tant que couche adhésive est déposée une couche en métal ou une couche en CrN qui, en présentant une part de métal ou de CrN décroissant et une part de WC croissant, se transforme en une couche en WC qui est ensuite pourvue d'une couche en W-C:H, la couche intermédiaire (24) avec le constituant principal DLC est déposée respectivement sur la couche en W-C:H, et le métal de la couche de métal est choisi parmi le groupe comprenant Cr, Ti, Al, Zr, V ou des combinaisons de ceux-ci.

8. Procédé selon la revendication 7,
**caractérisé en ce que**
le matériau porteur est constitué en une matière plastique et est choisi en particulier parmi le groupe comprenant ABS, polycarbonate, PMMA, polypropylène, polystyrène, polyéthylène, polyamide ou de la résine synthétique ou des mélanges desdites matières plastiques, y compris une ou plusieurs desdites matières plastiques avec renforcement de fibres, ou il est constitué en un métal ou un alliage de métal et choisi par exemple parmi le groupe comprenant aluminium, laiton, magnésium et acier inoxydable, et il est en particulier un acier inoxydable avec 16 à 18 % de Cr et 8 à 12 % de Ni.

9. Procédé selon la revendication 7 ou 8,
**caractérisé en ce que**
une couche en Cr est déposée en tant que couche adhésive qui, en présentant une part de Cr décroissant et une part de WC croissant, se transforme en une couche en WC qui est ensuite pourvue d'une couche en W-C:H, ou une couche en CrN est déposée en tant que couche adhésive, le cas échéant sous la forme d'une couche en CrN graduée avec une part de Cr décroissant et avec une part de N croissant, qui se transforme graduellement en une couche en WC, la part de WC croissant en direction depuis la couche en CrN et la couche en WC est ensuite pourvue d'une couche en W-C:H, ou une couche en Ti est déposée en tant que couche adhésive qui, en présentant une part de Ti décroissant et une part de WC croissant, se transforme en une couche en WC qui est ensuite pourvue d'une couche en W-C:H.

10. Procédé selon l'une des revendications précédentes 7 à 9,
**caractérisé en ce que**
la couche décorative déposée par PVD et/ou CVD est soit une couche noire en Ti déposé par voie non réactive avec un revêtement en TiCrCN déposé par voie réactive, soit une couche en ZrCN déposée par PVD avec une couleur de laiton, d'or, de nickel ou de bronze, soit encore une couche en TiCN avec une couleur d'or, d'acier inoxydable, de bronze ou de cuivre, soit encore une couche en CrCN déposée par PVD avec une couleur d'acier inoxydable, soit encore une couche en ZrCrCN déposée par PVD avec une couleur d'anthracite, soit encore une couche en oxyde ou en oxynitrure déposée par PVD avec une couleur d'arc en ciel, telle que le bleu ou le vert, la couche d'oxyde ou d'oxynitrure étant formée en particulier par un oxyde ou par un oxynitrure d'un métal parmi le groupe comprenant Ti, Cr, soit encore une combinaison de ces métaux.

11. Procédé selon l'une des revendications 7 à 10,
**caractérisé en ce que**
il est mis en oeuvre dans une installation avec au moins une cible de pulvérisation cathodique pour le dépôt d'une éventuelle couche adhésive ou d'un éventuel système de couche adhésive et/ou de constituants de la couche décorative, avec un système PACVD pour fixer la couche intermédiaire avec du DLC comme constituant principal ou exclusif et avec au moins une source d'arc électrique pour la fixation d'une éventuelle couche adhésive ou d'un éventuel système de couche adhésive et/ou de constituants de la couche décorative.

12. Installation pour mettre en oeuvre un procédé selon l'une des revendications précédentes 7 à 11,
**caractérisée par** la combinaison dans une chambre à vide d'au moins un système de pulvérisation cathodique à magnétron avec au moins une cible de pulvérisation cathodique, un système PACVD et un système d'évaporation par arc électrique avec au moins une source d'arc.
